# EUROPEAN PATENT APPLICATION

(11) **EP 2 515 356 A2**
(43) Date of publication of application: **24.10.2012**
(21) Application number: 12164981.8
(22) Date of filing: 20.04.2012
(51) Int. Cl.: H01L 33/64

(54) **Light emitting device package and method of manufacturing the same**

(30) Priority: 21.04.2011 KR 20110037287
(71) Applicant: Samsung LED Co., Ltd., Gyeonggi-Do (KR)
(72) Inventor: Yoo, Cheol Jun, Chungcheongnam-do (KR)
(74) Representative: Zimmermann & Partner

(57) **Abstract**

There are provided a light emitting device package (1) and a method of manufacturing the same. The light emitting device package (1) includes a light emitting device (10) including electrode pads (11); a body part (20) supporting the light emitting device (10), including a reflective groove (21) exposing an upper surface (10a) of the light emitting device (10) in an upper surface (20a) thereof, and exposing a lower surface (10b) of the light emitting device (10) through a lower surface (20b) thereof; and a lens part (30) provided on the body part (20) and covering the light emitting device (10).

## Description

### CROSS-REFERENCE TO RELATED APPLICATIONS

This application claims the priority of Korean Patent Application No. 10-2011-0037287 filed on April 21, 2011, in the Korean Intellectual Property Office, the disclosure of which is incorporated herein by reference.

### BACKGROUND OF THE INVENTION

### Field of the Invention

The present invention relates to a light emitting device package and a method of manufacturing the same.

### Description of the Related Art

In general, a light emitting device package made of a light emitting diode (LED), allowing for the emission of light according to an electrical signal applied thereto, has been widely used as a light emitting source for a variety of electronic products, as well as in a mobile communications terminal, such as a personal mobile phone, a personal digital assistant (PDA) or the like.

A light emitting diode is a kind of light emitting device capable of emitting light of various colors through the modification of a compound semiconductor material, such as gallium arsenide (GaAs), aluminum gallium arsenide (AlGaAs), gallium nitride (GaN), InGaInP or the like.

In the light emitting device as a light source, increases in luminous flux have been continuously demanded, and to this end, the size of a chip needs to be increased together with improvements to the performance thereof. Accordingly, from chips having a size of several hundred µm in the past, chips having a size of several millimeters (mm) have recently emerged. As the area of a growth substrate for depositing a semiconductor layer, such as GaN, has enlarged, it is expected that an increase in the size of a chip may be accelerated.

However, an increase in the size of a chip may generate a greater amount of heat, as compared to that generated during the operation of a light emitting device chip, such that an attempt at emitting heat more efficiently is required. Typically, heat management operations of a light emitting device may be classified into a package level, a module level, a system level or the like, and research into a structure allowing for the maximization of heat radiation efficiency has been actively undertaken.

### SUMMARY OF THE INVENTION

An aspect of the present invention provides a light emitting device package in which a bottom surface of a chip is exposed to a lower portion of a package body and comes into direct contact with a mounting substrate, such that heat generated during an operation thereof may be emitted directly to the mounting substrate to thereby allow for maximization of heat radiation efficiency, and a method of manufacturing the same.

An aspect of the present invention also provides a light emitting device package in which a chip and a wire are sealed through a use of a molding material having excellent mechanical, electrical properties, rather than a sealing material, thereby allowing for an improvement in wire bonding reliability.

According to an aspect of the present invention, there is provided a light emitting device package, including: a light emitting device including electrode pads; and a body part supporting the light emitting device, including a reflective groove exposing an upper surface of the light emitting device in an upper surface thereof, and exposing a lower surface of the light emitting device through a lower surface thereof.

The light emitting device may include electrode pads on the upper surface thereof or the upper surface and lower surface thereof, and the electrode pads included on the upper surface may be sealed by the body part.

The light emitting device package may further include bonding wires and electrode terminals electrically connected to the electrode pads through the bonding wires, wherein the bonding wires and the electrode terminals may be integrally sealed and supported by the body part, together with the light emitting device, and the electrode terminals may have lower surfaces exposed through the lower surface of the body part.

Each of the electrode terminals may include prominences, such as projections, and depressions allowing for enhanced coupling force with the body part, on at least one surface thereof.

The light emitting device may include the electrode pads on the lower surface thereof, and the electrode pads may be exposed through the lower surface of the body part.

The light emitting device may have side surfaces sealed by the body part, and the side surfaces may be inclined such that the light emitting device has an inverted pyramid shape.

The body part may be formed in such a manner that the upper surface thereof is located to be coplanar with the upper surface of the light emitting device exposed through the reflective groove.

The light emitting device package may further include a sealing part formed within the reflective groove and covering the upper surface of the light emitting device.

The sealing part may include any one of a fluorescent material, a diffusion material, and a mixture of the diffusion and fluorescent materials.

The light emitting device package may further include a lens part provided on the body part and covering the light emitting device.

The light emitting device package may further include a fluorescent layer formed on the upper surface of the light emitting device.

According to another aspect of the present invention, there is provided a method of manufacturing a light emitting device package, the method including: mounting a light emitting device including electrode pads on a carrier film; forming a body part on the carrier film through molding so as to seal the light emitting device by injecting a resin within a mold and to have a reflective groove formed in an upper surface thereof, the reflective groove exposing an upper surface of the light emitting device; and removing the carrier film.

The method may further include forming a lens part on the body part to cover the light emitting device.

The method may further include patterning electrode terminals on the carrier film before the mounting of the light emitting device.

The light emitting device may include the electrode pads on the upper surface thereof or includes the electrode pads on the upper surface and a lower surface thereof, and the method may further include electrically connecting the electrode pads included on the upper surface and the electrode terminals through bonding wires.

In the forming of the body part, the light emitting device having the upper surface exposed through the reflective groove may be integrally sealed together with the electrode terminals and the bonding wires.

The light emitting device may include the electrode pads on a lower surface thereof coming into contact with the carrier film, and in the forming of the body part, the body part may be molded so as to cover a surface of the light emitting device, except for the electrode pads and the upper surface exposed through the reflective groove.

In the forming of the body part, the body part may be formed in such a manner that the upper surface thereof is located on the same plane as the upper surface of the light emitting device, or located on a plane different from the upper surface of the light emitting device.

The method may further include forming a fluorescent layer on the upper surface of the light emitting device between the formation of the body part and the formation of the lens part.

The method may further include tesing the light emitting device by inserting a probe electrode into a probe through hole provided in the carrier film, before the removing of the carrier film.

The probe through hole may be provided in a location of the carrier film electrically connected to the electrode pads.

The method may further include dicing through a cutting appratus.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a cross-sectional view schematically showing a light emitting device package according to an embodiment of the present invention;
FIGS. 2A and 2B are plan views schematically showing various shapes of an electrode terminal connected to a light emitting device through a bonding wire from FIG. 1;
FIGS. 3A and 3B are plan views schematically showing various shapes of a reflective groove exposing an upper surface of the light emitting device from FIG. 1;
FIG. 4 is a cross-sectional view of FIGS. 3A and 3B;
FIG. 5 is a cross-sectional view schematically showing a modified example of the light emitting device package shown in FIG. 1;
FIG. 6 is a cross-sectional view schematically showing a light emitting device package according to another embodiment of the present invention;
FIGS. 7A through 7C are plan views schematically showing various shapes of an electrode terminal connected to a light emitting device through a bonding wire from FIG. 6;
FIGS. 8A and 8B are plan views schematically showing various shapes of a reflective groove exposing an upper surface of the light emitting device from FIG. 6;
FIG. 9 is a cross-sectional view schematically showing a light emitting device package according to another embodiment of the present invention;
FIGS. 10A and 10B are plan views of FIG. 9;
FIGS. 11A through 11D are cross-sectional views schematically showing various shapes of a body part sealing a light emitting device from FIG. 9;
FIGS. 12A and 12B are cross-sectional views, respectively schematically showing a state in which the light emitting device package of FIG. 1 is mounted on a substrate and a state in which the light emitting device package of FIG. 6 is mounted on a substrate;
FIGS. 13A and 13B are cross-sectional views, respectively schematically showing a state in which the light emitting device package of FIG. 9 is mounted on a substrate; and
FIGS. 14 through 22 are views schematically showing a method of manufacturing the light emitting device package according to an embodiment of the present invention in respective processes.

### DETAILED DESCRIPTION OF THE INVENTION

Embodiments of the present invention will now be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art.

In the drawings, the shapes and sizes of components are exaggerated for clarity. The same or equivalent elements are referred to by the same reference numerals throughout the specification.

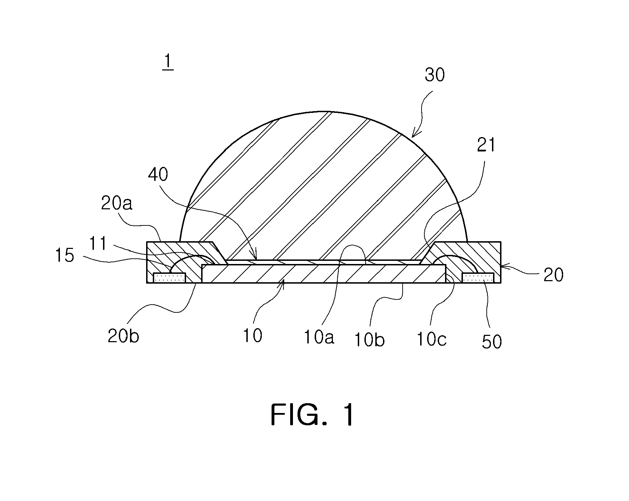

A light emitting device package according to an embodiment of the present invention will be explained with reference to FIGS. 1 through 4.

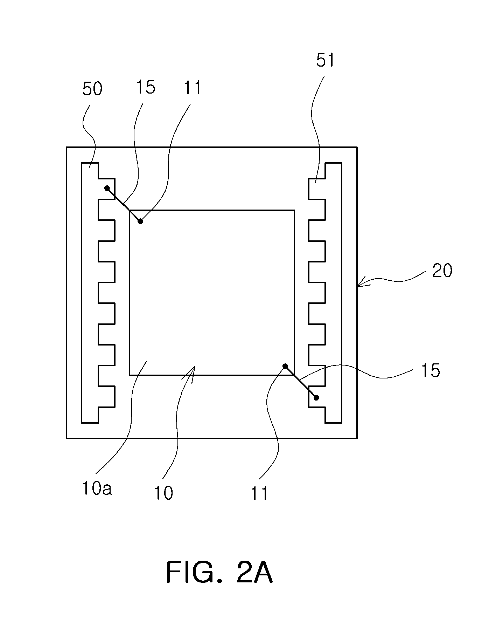

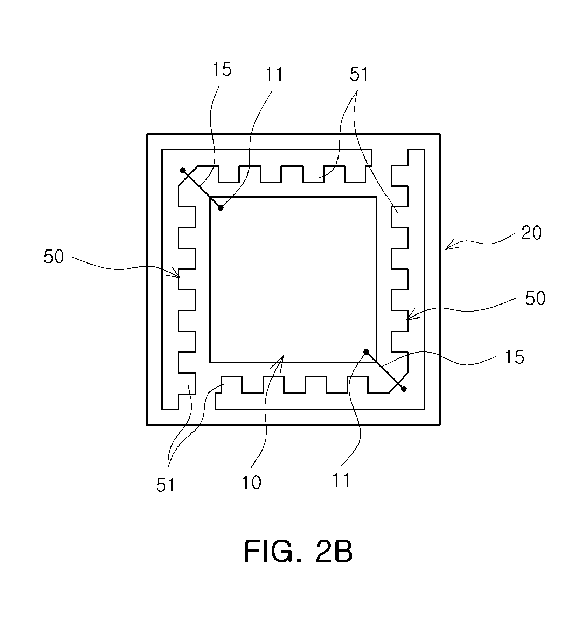

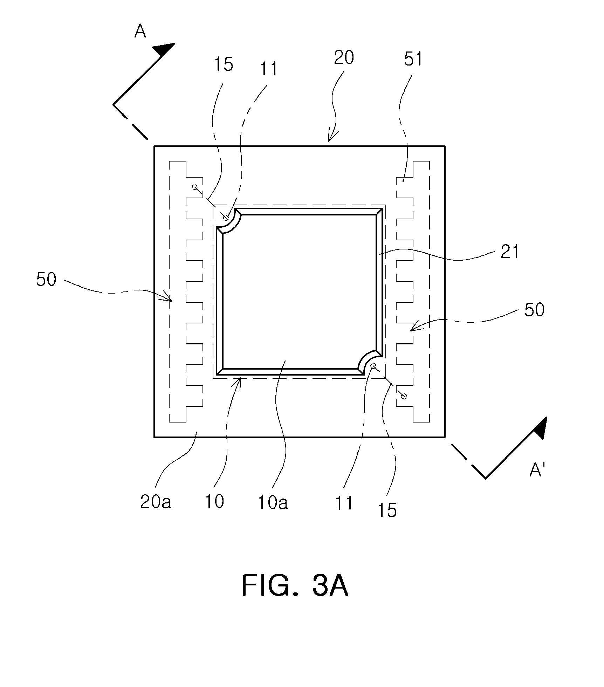

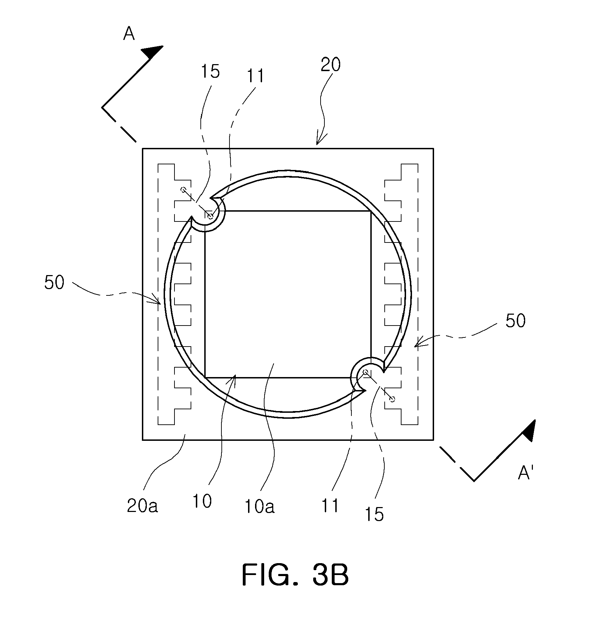

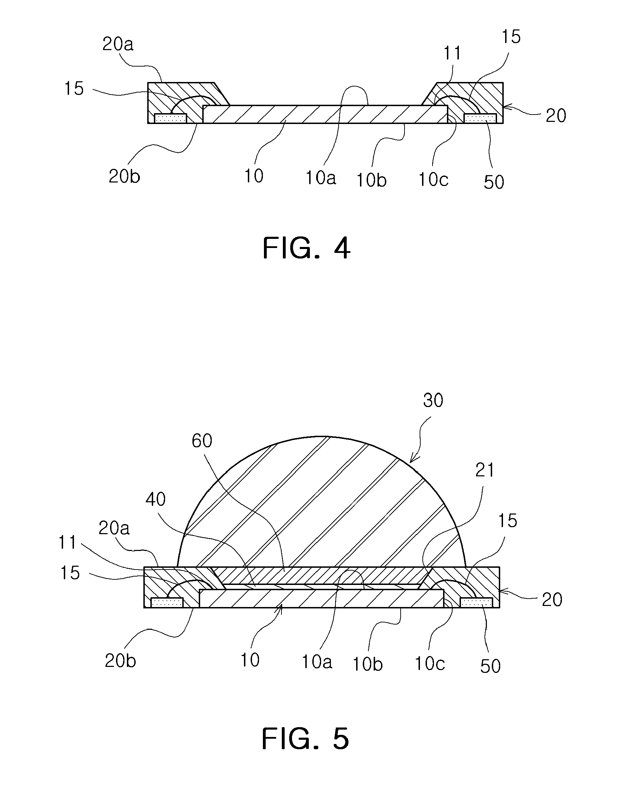

FIG. 1 is a cross-sectional view schematically showing a light emitting device package according to an embodiment of the present invention. FIGS. 2A and 2B are plan views schematically showing various shapes of an electrode terminal connected to a light emitting device through a bonding wire from FIG. 1. FIGS. 3A and 3B are plan views schematically showing various shapes of a reflective groove exposing an upper surface of the light emitting device from FIG. 1. FIG. 4 is a cross-sectional view of FIGS. 3A and 3B.

Referring to FIGS. 1 through 4, a light emitting device package 1 according to an embodiment of the present invention may include a light emitting device 10, a body part 20, and a lens part 30, and may further include a fluorescent layer 40 formed on an upper surface of the light emitting device 10.

The light emitting device 10 is a semiconductor element emitting light of a predetermined wavelength by an electrical signal applied from the outside, and may include a light emitting diode. The light emitting device 10 may emit blue light, red light, or green light according to a material contained therein, and may also emit white light.

The light emitting device 10 may emit light through an upper surface 10a and side surfaces 10c thereof. However, the light emitting device 10 may mainly emit light through the upper surface 10a thereof, a light emitting surface. The upper surface 10a of the light emitting device 10 may include electrode pads 11 formed thereon for a connection with bonding wires 15.

As in FIGS. 1 through 4, the electrode pads 11 may be adjacent around the circumference of the upper surface 10a of the light emitting device 10 and be provided in plural. The electrode pads 11 may be, for example, a pair of a P-type electrode and an N-type electrode.

As in FIGS. 1 through 4, the light emitting device 10 may be singularly provided; however, the light emitting device 10 may be provided in plural and the plurality of light emitting devices 10 may be arranged in a matrix structure. The light emitting devices 10 arranged within the same package may be homogeneous or heterogeneous.

Electrode terminals 50 may be provided to be adjacent to the light emitting device 10 at sides thereof, the electrode terminals 50 being individually electrically connected to the electrode pads 11. The electrode terminals 50 may have one ends connected to the other ends of the bonding wires 15 connected to the electrode pads 11, thereby being electrically connected to the electrode pads 11.

As in FIGS. 1 through 4, the electrode terminals 50 may be individually provided at two sides of the light emitting device 10, corresponding to the electrode pads 11. For example, in a case in which the electrode pads 11 may include a P-type electrode and an N-type electrode, the electrode terminals 50 may correspond to the respective electrodes to be electrically connected.

As shown in FIG. 2A, the electrode terminals 50 may be disposed at two sides of the light emitting device 10 in such a manner that the electrode terminals 50 are opposed to each other while having the light emitting device 10 therebetween. In addition, as shown in FIG. 2B, the electrode terminals 50 may be extended along four sides of the light emitting device 10 and disposed so as to surround the light emitting device 10. In this case, due to an increase in the areas of the electrode terminals 50, a connection of the bonding wires 15 with the electrode terminals 50 may be facilitated, and an electrical connection of a light emitting device package 1 according to an embodiment of the present invention with a substrate, which will have the light emitting device package mounted thereon may be facilitated. Moreover, improvements in heat radiation efficiency through the electrode terminals 50 may be expected.

Each of the electrode terminals 50 may include prominences, such as projections, and depressions 51 allowing for enhanced coupling force between the electrode terminal 50 and the body part 20, on at least one surface thereof. The prominences and depressions 51 may allow for an increase in a contact area between the electrode terminal 50 and the body part 20 which is molded so as to surround the electrode terminal 50 and seals the electrode terminal 50, thereby enhancing coupling force between the electrode terminal 50 and the body part 20.

FIGS. 1 through 4 illustrate that a pair of the electrode terminals 50 are provided; however, the number and disposition location of the electrode terminals 50 may be variously modified.

The body part 20 may include the bonding wires 15 and the electrode pads 11 to thereby integrally seal and support the light emitting device 10 and the electrode terminals 50. Concretely, the body part 20 may cover and integrally seal the side surfaces 10c of the light emitting device 10 together with the bonding wires 15, and a part of the upper surface 10a of the light emitting device 10, the part including the electrode pads 11.

The body part 20 may be made of a white molding compound, which may lead to an increase in quantity of light, the light being emitted from the side surfaces 10c of the light emitting device 10 and reflected to be thereby upwardly emitted. The white molding compound may include a thermosetting resin series or a silicon resin series having high heat-resisting properties. In addition, the thermosetting resin series may contain a white pigment and filling material, a hardener, a release agent, an antioxidant, an adhesion improver, or the like added therein, and have a high glass transition temperature (Tg) of 100°C or more, a low coefficient of thermal expansion (CTE) of 20 ppm or less, and a high adhesive strength. Thus, the light emitting device 10 and the bonding wires 15 are integrally sealed by the body part having superior mechanical properties, rather than being sealed by a lens material-sealing part having low mechanical properties as in the related art, whereby connection reliability between the light emitting device 10 and the bonding wires 15 may be secured.

The body part 20 may include a reflective groove or opening 21 in an upper surface 20a thereof, the reflective groove 21 exposing the upper surface 10a, the light emitting surface of the light emitting device 10. In this case, since the part of the upper surface 10a of the light emitting device 10, including the electrode pads 11 formed thereon, may be sealed by the body part 20, it may be not exposed through the reflective groove 21. The upper surface 20a of the body part 20 may be higher than the upper surface 10a of the light emitting device 10 such that the light emitting device 10 is not protruded upwardly of the upper surface 20a of the body part 20.

As in FIGS. 1 and 4, the reflective groove 21 may have a cup structure in which an inner surface thereof is downwardly inclined towards the light emitting device 10 to have a tapered shape. Alternatively, the reflective groove 21 may have a quadrangular shape corresponding to that of the light emitting device 10, as in FIG. 3A. Alternatively, the reflective groove 21 may have a round shape as in FIG. 3B, and may also have a polygonal shape in consideration of light-reflecting properties.

A lower surface 10b of the light emitting device 10 and respective lower surfaces of the electrode terminals 50 may be exposed through a lower surface 20b of the body part 20. In addition, side surfaces of the electrode terminals 50 may be exposed through side surfaces of the body part 20.

In this manner, the light emitting device 10 may be exposed directly to the outside through the lower surface 20b of the body part 20, such that heat generated from the light emitting device 10 may be directly emitted to the outside to thereby allow for maximized heat radiation efficiency. In particular, components having a light emitting device mounted thereon and electrically connected thereto, such as lead frames or substrates as in the related art may be omitted, such that the number of components, as well as spaces occupied by the lead frames or substrates may be reduced to thereby allow for slimness in the package.

The lens part 30 may be provided on the body part 20 to cover and protect the light emitting device 10. The lens part 30 may be made of a transparent resin material such that light emitted from the light emitting device 10 is smoothly emitted to the outside. The lens part 30 may have an upwardly convex dome shape as shown in FIGS. 1 through 4, in order to improve an orientation angle of emitted light. However, the shape of the lens part 30 is not limited thereto and may be varied in consideration of orientation angle properties.

The lens part 30 may be formed directly on the body part 20 by a molding method, such as a compression molding method, a transfer molding method or the like, or a potting method using a dispenser. The lens part 30 may also be fabricated through a separate process to be adhered to the body part 20 through an adhesive or the like.

The fluorescent layer 40 may be formed within the reflective groove 21 so as to cover the upper surface 10a of the light emitting device 10. The fluorescent layer 40 may contain at least one kind of fluorescent material, such that a wavelength of light emitted from the light emitting device 10 may be converted into a wavelength thereof exhibiting a desired color. For example, blue light may be converted into white light. As in FIGS. 1 through 4, a light emitting area (an area from which light is emitted) of the upper surface 10a of the light emitting device 10 may be exposed through the reflective groove 21, such that the fluorescent layer 40 may allow for the dispersion of fluorescent materials only on the light emitting area of the light emitting device 10, thereby leading to a reduction in the amount of relatively expensive fluorescent materials used. In addition, since the body part 20 may allow only the light emitting area of the light emitting device 10 to be exposed through the reflective groove 21, the fluorescent layer 40 may be easily formed only on the light emitting area. The fluorescent layer 40 may be omitted in a case in which the light emitting device 10 emits white light by itself.

The fluorescent layer 40 may be formed by injecting a resin containing fluorescent materials in the reflective groove 21 and curing the resin or through the disposition or deposition of the resin. In addition, the fluorescent layer 40 may be formed before the singulating of the light emitting device 10 into an individual die on a wafer level.

FIG. 5 is a cross-sectional view schematically showing a modified example of the light emitting device package shown in FIG. 1. Components constituting the light emitting device package according to a modified example illustrated in FIG. 5 may have substantially the same in basic structures as those of the light emitting device package according to the embodiment illustrated in FIGS. 1 through 4. However, the light emitting device package according to a modified example illustrated in FIG. 5 is different from the light emitting device package according to the embodiment illustrated in FIGS. 1 through 4, in that a sealing part 60 is further included between the fluorescent layer 40 and the lens part 30.

The sealing part 60 may be formed within the reflective groove 21 to cover the upper surface of the light emitting device 10. Concretely, the sealing part 60 may be disposed between the fluorescent layer 40 formed on the upper surface 10a of the light emitting device 10 and the lens part 30 provided on the body part 20, to fill the reflective groove 21. However, in the case of an omission of the fluorescent layer 40, the sealing part 60 may come into direct contact with the upper surface 10a of the light emitting device 10.

The sealing part 60 may be made of a transparent resin such that light emitted from the light emitting device 10 is smoothly emitted to the outside, similarly to the lens part 30. The sealing part 60 may be made of a material having a refractive index equal to that of a material of the lens part 30. The sealing part 60 may also be made of a material having a refractive index different from that of a material of the lens part 30, in order to allow for an adjustment in an orientation angle of emitted light. In this case, a refractive index of the sealing part 60 may be lower than that of the lens part 30.

The sealing part 60 may contain a fluorescent material to convert a wavelength of light generated from the light emitting device 10 into a desired wavelength thereof. In this case, the fluorescent material contained in the sealing part 60 is different from that of the fluorescent layer 40 contained therein. In addition, in a case in which the sealing part 60 contains a fluorescent material, the fluorescent layer 40 may be omitted. Moreover, the sealing part 60 may contain a diffusion material to diffuse light, in addition to the fluorescent material, or contain a mixture of the diffusion and fluorescent materials.

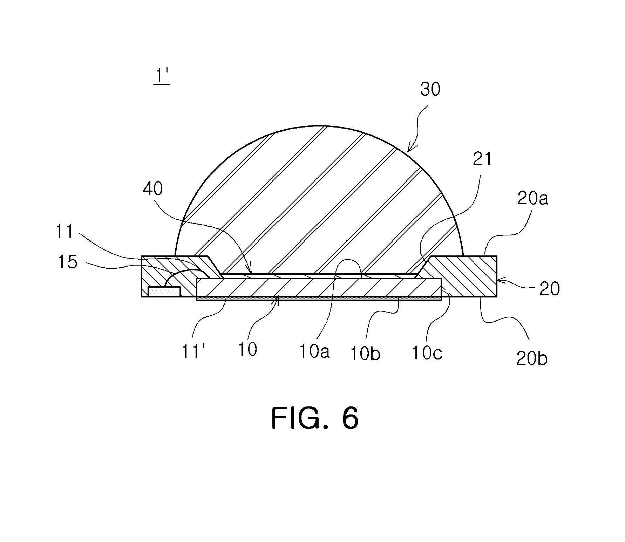

With reference to FIGS. 6 through 8, a light emitting device package 1' according to another embodiment of the present invention will be explained.

Components constituting a light emitting device package according to another embodiment illustrated in FIGS. 6 through 8 may have substantially the same in basic structures as those of the light emitting device package according to the embodiment illustrated in FIGS. 1 through 5. However, in the light emitting device package according to another embodiment illustrated in FIGS. 6 through 8, an electrode pad structure of a light emitting device and a connection structure between the light emitting device and electrode pads according to the electrode pad structure may be different from those of the light emitting device package according to the embodiment illustrated in FIGS. 1 through 5. Thus, hereinafter, a description of parts overlapping with those of the foregoing embodiment will be omitted and constitutions regarding the light emitting device and electrode terminals may be mainly explained.

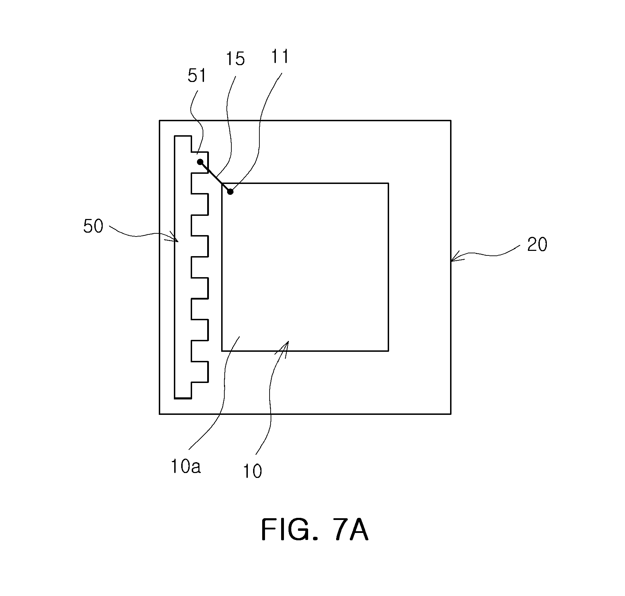

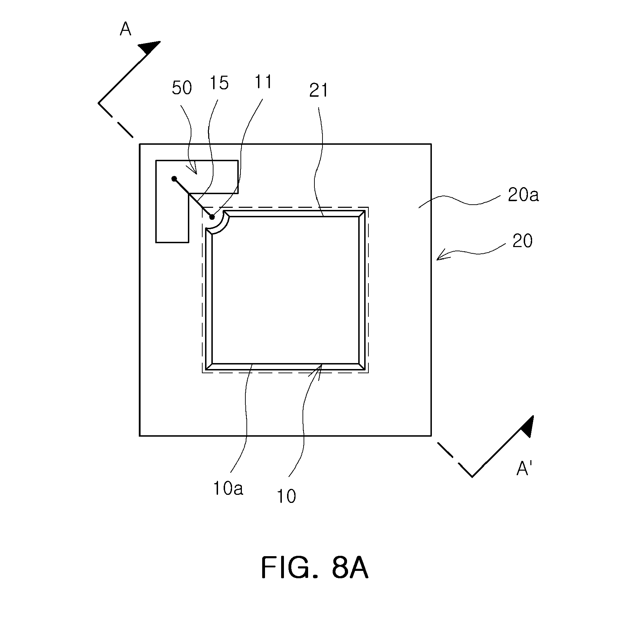

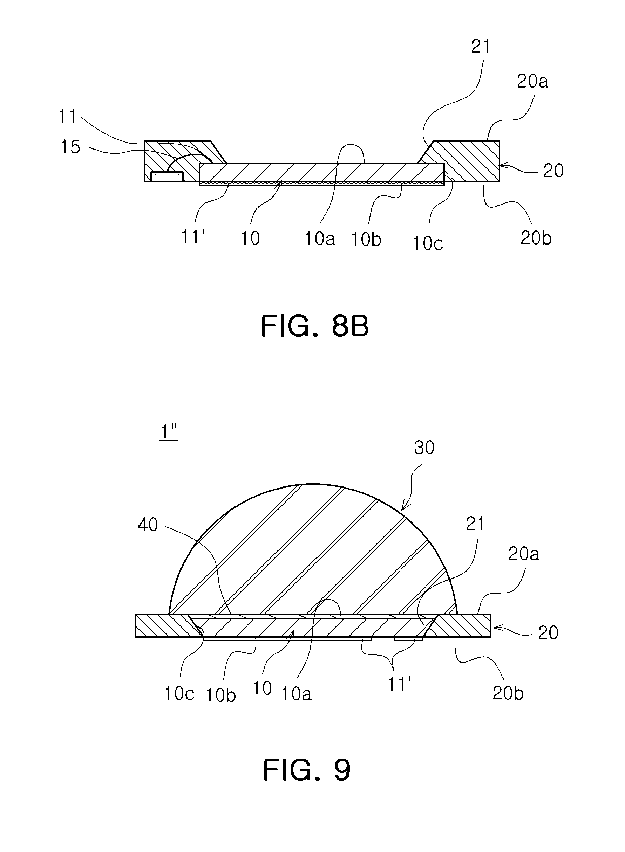

FIG. 6 is a cross-sectional view schematically showing a light emitting device package according to another embodiment of the present invention. FIGS. 7A through 7C are plan views schematically showing various shapes of an electrode terminal connected to a light emitting device through a bonding wire from FIG. 6. FIGS. 8A and 8B are plan views schematically showing various shapes of a reflective groove exposing an upper surface of the light emitting device from FIG. 6.

As illustrated in FIGS. 6 through 8, the light emitting device 10 may include electrode pads 11 and 11' on the upper surface 10a and the lower surface 10b thereof, respectively. The electrode pad 11 formed on the upper surface 10a of the light emitting device 10 may be connected to the bonding wire 15 and may be formed to be adjacent around the circumference of the upper surface 10a of the light emitting device 10, as illustrated in FIGS. 6 through 8. The electrode pad 11' formed on the lower surface 10b of the light emitting device 10 may be entirely formed over the lower surface 10b of the light emitting device 10. The electrode pads 11 and 11' are a P-type electrode and an N-type electrode, respectively.

As in FIGS. 6 through 8, the light emitting device 10 may be singularly provided; however, the light emitting device 10 may be provided in plural and the plurality of light emitting devices 10 may be arranged in a matrix structure. The light emitting devices 10 arranged within the same package may be homogeneous or heterogeneous.

The electrode terminal 50 may be provided to be adjacent to the light emitting device 10 at a side thereof, the electrode terminal 50 being electrically connected to the electrode pad 11 formed on the upper surface 10a of the light emitting device 10. The electrode terminal 50 may have one end connected to the other end of the bonding wire 15 connected to the electrode pad 11, thereby being electrically connected to the electrode pad 11.

The electrode terminal 50 may have an electrode identical to that of the electrode pad 11. The electrode terminal 50 may include one or more electrode terminals. As illustrated in FIG. 7A, the electrode terminal 50 may be disposed along a side of the light emitting device 10, the side being adjacent to the electrode pad 11. The electrode terminal 50 may include prominences and depressions 51 formed on at least one surface thereof to thereby enhance coupling force between the electrode terminal 50 and the body part 20.

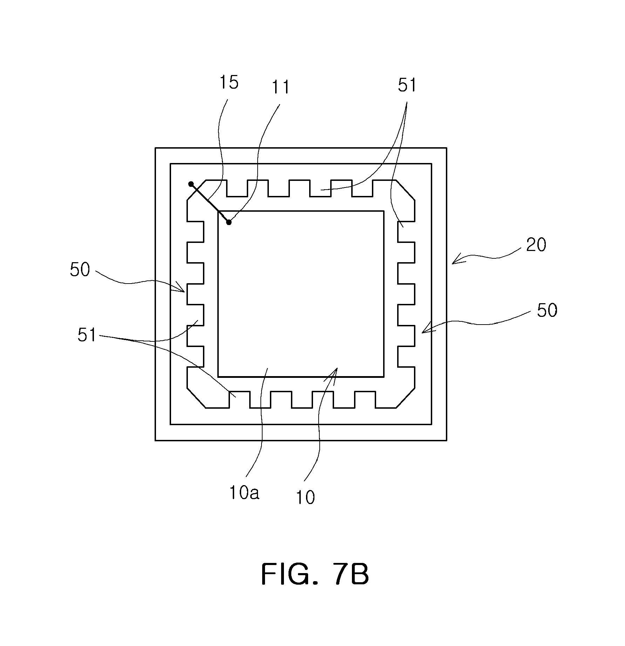

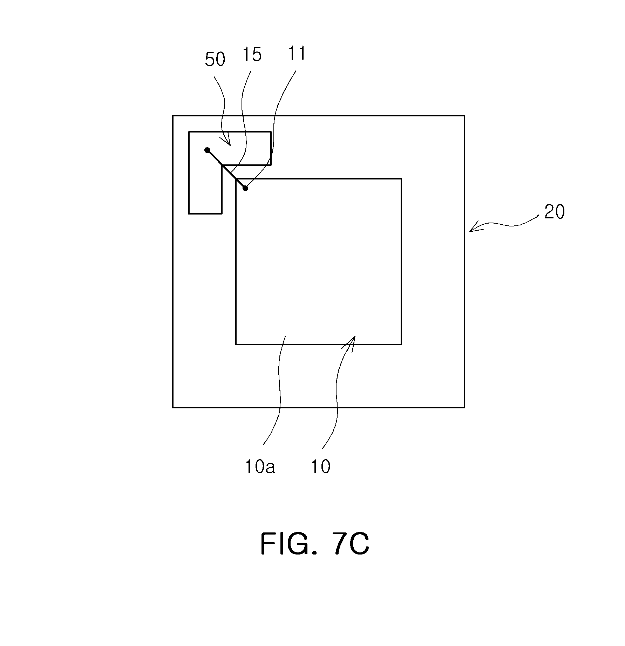

As illustrated in FIG. 7B, the electrode terminal 50 may be disposed in such a manner as to surround the circumference of the light emitting device 10. Also, as illustrated in FIG. 7C, the electrode terminal 50 may be disposed around an edge of the light emitting device, the edge being adjacent to the electrode pad 11 and may be electrically connected to the electrode pad 11 through the bonding wire 1.

The body part 20 may include the bonding wire 15 and the electrode pad 11 connected thereto, thereby integrally sealing and supporting the light emitting device 10 and the electrode terminal 50. In this case, among the electrode pads 11 and 11' respectively provided on the upper surface 10a and the lower surface 10b of the light emitting device 10, only the electrode pad 11 included on the upper surface 10a of the light emitting device is sealed by the body part 20 and may not be exposed to the outside.

Concretely, the body part 20 may cover and integrally seal the side surfaces 10c of the light emitting device 10 together with the bonding wire 15, and the part of the upper surface 10a of the light emitting device 10 including the electrode pad 11. Thus, the light emitting device 10 and the bonding wire 15 are integrally sealed by the body part 20 having superior mechanical properties, rather than being sealed by a sealing part having low mechanical properties as in the related art, whereby connection reliability between the light emitting device 10 and the bonding wire 15 may be secured.

The electrode pad 11' provided on the lower surface 10b of the light emitting device 10 and the lower surface of the electrode terminal 50 may be exposed through the lower surface 20b of the body part 20. In addition, the side surface of the electrode terminal 50 may be exposed through the side surface of the body part 20.

With reference to FIGS. 9 through 11, a light emitting device package 1" according to another embodiment of the present invention will be explained.

Components constituting a light emitting device package according to another embodiment illustrated in FIGS. 9 through 11 may have substantially the same in basic structures as those of the light emitting device packages according to the embodiment illustrated in FIGS. 1 through 8. However, in the light emitting device package according to another embodiment illustrated in FIGS. 9 through 11, an electrode pad structure of a light emitting device and an omission of an electrode terminal according to the electrode pad structure, as well as a body part structure sealing the light emitting device, may be different from those of the light emitting device packages according to the embodiment illustrated in FIGS. 1 through 8. Thus, hereinafter, a description of parts overlapping with those of the foregoing embodiments will be omitted and constitutions regarding the light emitting device may be mainly explained.

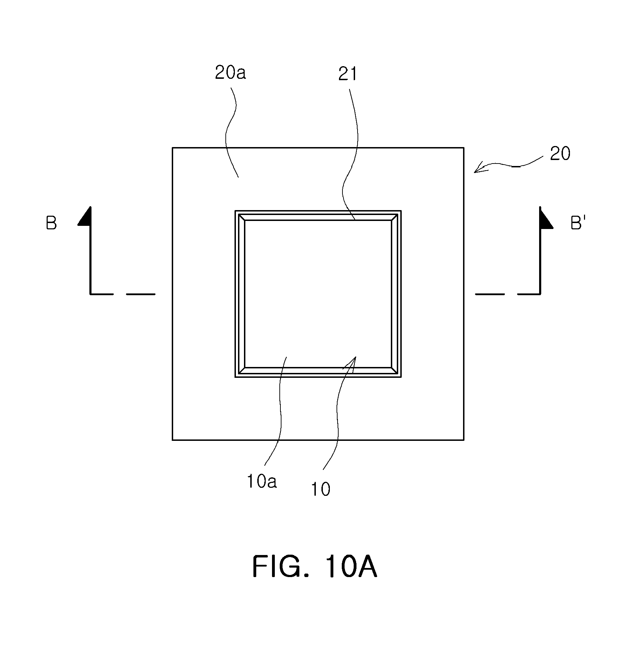

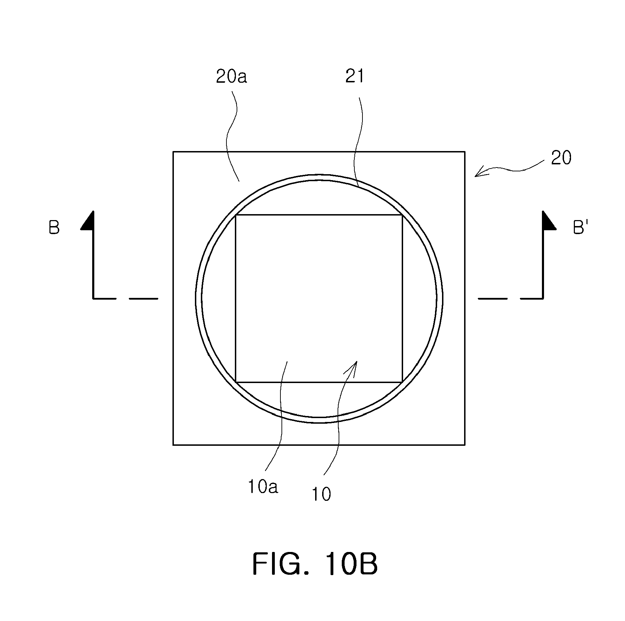

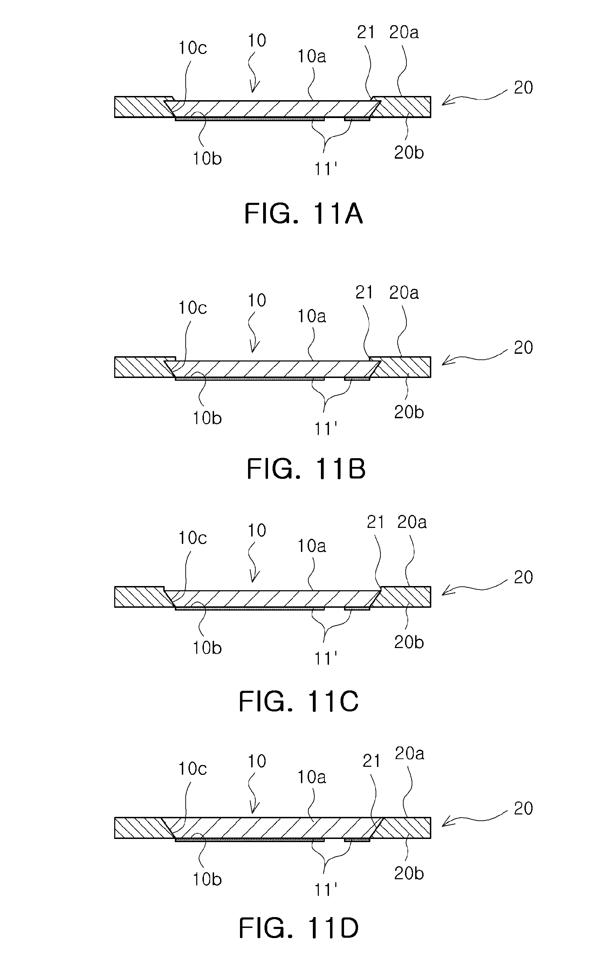

FIG. 9 is a cross-sectional view schematically showing a light emitting device package according to another embodiment of the present invention. FIGS. 10A and 10B are plan views of FIG. 9. FIGS. 11A through 11D are cross-sectional views schematically showing various shapes of a body part sealing a light emitting device from FIG. 9.

As illustrated in FIGS. 9 through 11, the light emitting device 10 may include the electrode pads 11' formed on the lower surface 10b opposing to the upper surface 10a, the light emitting surface of the light emitting device 10. As illustrated in FIGS. 9 through 11, the electrode pads 11' formed on the lower surface 10b of the light emitting device 10 may be provided in plural and the plurality of electrode pads 11' may be formed over the lower surface 10b of the light emitting device 10 in such a manner as to be separate from each other, in respect of electrical connection and heat radiation. The plurality of electrode pads 11' may be a P-type electrode and an N-type electrode.

The side surfaces 10c of the light emitting device 10 may be inclined in such a manner that the light emitting device 10 may have an inverted pyramid shape in which the upper surface 10a thereof has a greater area than the lower surface 10b thereof.

As in FIGS. 9 through 11, the light emitting device 10 may be singularly provided; however, the light emitting device 10 may be provided in plural and the plurality of light emitting devices 10 may be arranged in a matrix structure. The light emitting devices 10 arranged within the same package may be homogeneous or heterogeneous.

The body part 20 may seal and support the light emitting device 10. Concretely, the body part 20 may seal the light emitting device 10 in such a manner that the upper surface 10a of the light emitting device 10 is exposed to the outside through the reflective groove 21 provided in the upper surface 20a of the body part 20 and the lower surface 10b of the light emitting device 10 including the electrode pad 11' is exposed to the outside through the lower surface 20b of the body part 20. Thus, the light emitting device 10 may be molded and fixed into the body part 20 in such a manner that the side surfaces 10c thereof inclined at a predetermined angle are sealed by the body part 20 and are not exposed to the outside while both of the upper surface 10a and the lower surface 10b thereof are exposed from the body part 20.

The light emitting device 10 may be directly supplied with external power through the electrode pad 11' exposed to the lower surface 20b of the body part 20. In this case, the electrode pad may be formed on the upper surface 10a of the light emitting device 10, sealed by the body part, as in the light emitting device illustrated in FIGS. 1 through 6. Thus, the package may not need to include the electrode terminal and bonding wire for power supply, to thereby have a simplified structure and a slimmer size.

In particular, since the body part 20 may seal the inclined side surfaces 10c of the light emitting device 10, light emitted through the inclined side surfaces 10c of the light emitting device 10 may be reflected from an interface between the side surfaces 10c and the body part 20 to be advanced in the direction of the upper surface 10a. Thus, luminous flux may be improved.

As illustrated in FIG. 11A, the body part 20 may be formed in such a manner that the reflective groove 21 through which the upper surface 10a of the light emitting device 10 is exposed may partially cover the circumference of the upper surface 10a of the light emitting device 10 and may be inclined at a predetermined angle or may be vertically stepped as in FIG. 11B. In addition, as in FIG. 11C, the body part 20 may be formed in such a manner that the upper surface 20a thereof may be located to be coplanar with the upper surface 10a of the light emitting device 10 exposed through the reflective groove 21.

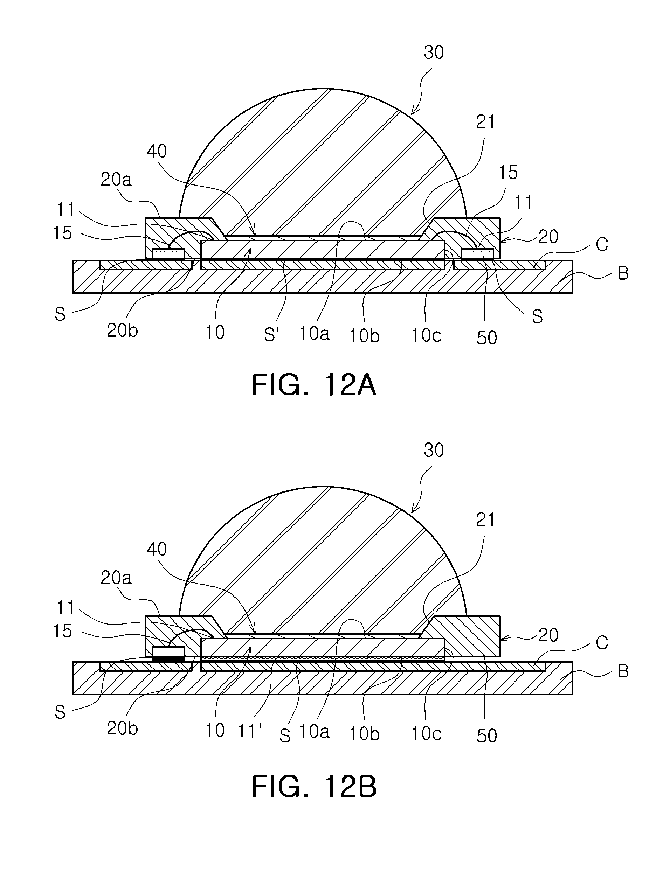

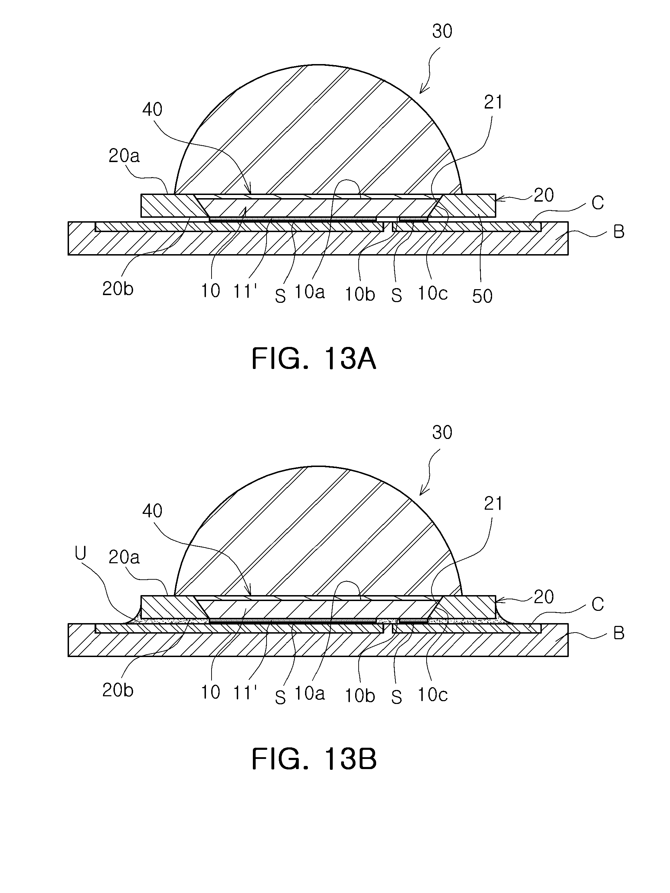

FIGS. 12A and 12B are cross-sectional views, respectively schematically showing a state in which the light emitting device package of FIG. 1 is mounted on a substrate and a state in which the light emitting device package of FIG. 6 is mounted on a substrate. FIGS. 13A and 13B are cross-sectional views, respectively schematically showing a state in which the light emitting device package of FIG. 9 is mounted on a substrate.

The light emitting device packages 1, 1' and 1" having a structure in which the lower surface of the light emitting device is exposed through the lower surface of the body part, according to the embodiments of the present invention illustrated in FIGS. 1 through 11, may be mounted on a substrate (B) included in a lighting device or other display devices (not shown) and may be used as a light source.

For example, as illustrated in FIGS. 12 and 13, the light emitting device packages 1, 1' and 1" may be individually mounted on the substrate (B) constituting a lighting device (not shown) and electrically connected to a circuit pattern (C). In this case, the electrode terminal 50 and/or the electrode pad 11' of each light emitting device package electrically connected to a circuit pattern (C) may be adhered to the circuit pattern (C)through a conductive adhesive S, such as a solder paste. The lower surface 10b of the light emitting device coming into contact with the substrate (B) may be adhered to the substrate (B) through an adhesive (S') having high thermal conductivity. Materials having high thermal conductivity include a nano-size metal composite, a CNT-metal composite, a CNT-polymer composite, a metal-polymer composite, a eutectic metal paste, or the like. In some case, as in FIG. 13B, a gap formed between the substrate (B) and the light emitting device package due to an adhesive may be filled with underfill (U). Through this, a bonding surface of the light emitting device package with the circuit pattern (C) may be protected, and a boundary surface of the body part 20 with the light emitting device 10 exposed from the body part 20 may be complemented, whereby moisture or the like may be prevented from infiltrating into the light emitting device package and the package may be protected from the outside.

In this manner, each of the light emitting device packages according to the embodiments of the present invention may have a structure in which the light emitting device 10 is exposed through the lower surface 20b of the body part 20. Thus, when the light emitting device package is mounted on the substrate (B) constituting a lighting device or the like, heat may be transferred towards the substrate (B) to be emitted to the outside, via the light emitting device 10 exposed to the lower surface of the body part 20. In addition, when the electrode pads 11' are provided on the exposed lower surface 10b of the light emitting device 10, electrical conduction and heat radiation may be performed through the electrode pads 11'. Thus, heat radiation efficiency may be maximized, as well as a size of a product reduced. In addition, the number of components, such as lead frames or substrates included in a general light emitting device package structure and having a light emitting device mounted thereon, may be reduced, whereby manufacturing costs may be reduced.

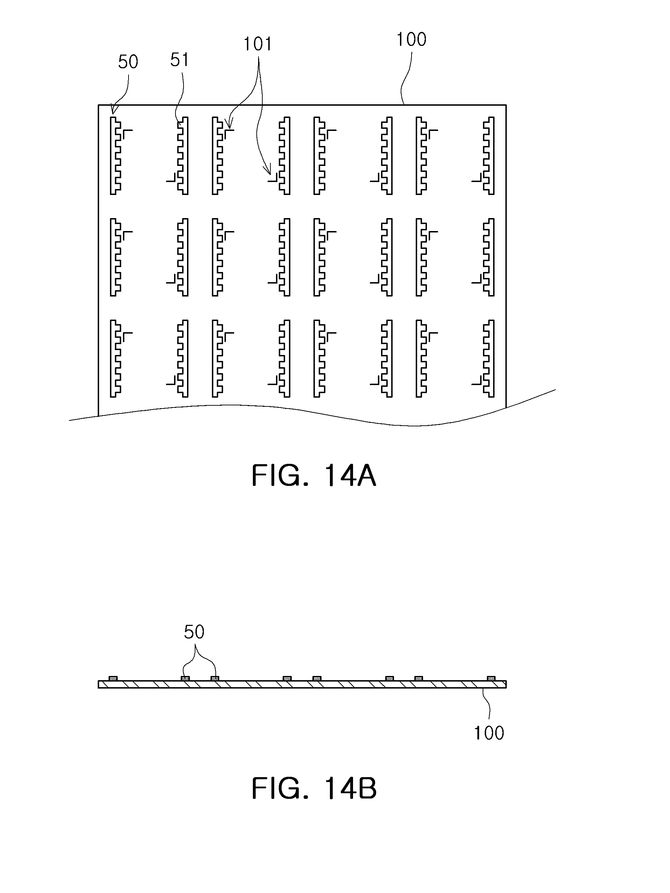

With reference to FIGS. 14 through 22, a method of manufacturing the light emitting device package according to an embodiment of the present invention may be described. FIGS. 14 through 22 are views schematically showing a method of manufacturing the light emitting device package according to an embodiment of the present invention in respective processes.

As illustrated in FIG. 14, the electrode terminals 50 may be patterned on a carrier film 100.

The carrier film 100, a thin film having heat resisting and insulating properties, is a supporting means having the light emitting device 10 mounted thereon and fixing the light emitting device 10 thereto. A fiducial mark 101 indicating a mounting position of the light emitting device 10 may be formed on a surface of the carrier film 100, corresponding to the mounting position of the light emitting device 10 (a position on which the light emitting device 10 is to be mounted).

The electrode terminals 50 may be a plurality of pairs of electrode terminals and arranged in horizontal and vertical directions to have a matrix arrangement.

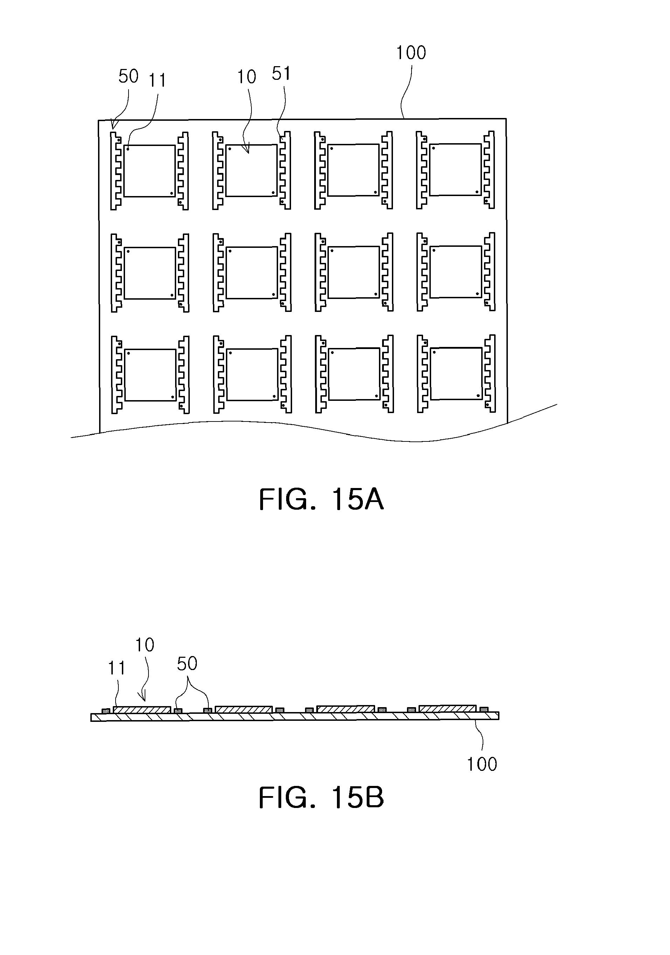

Next, as illustrated in FIG. 15, the light emitting device 10 may include one or more light emitting devices, and the one or more light emitting devices together with the electrode terminals 50 may be mounted on the carrier film 100.

The light emitting devices 10 may be prepared by singulating a light emitting laminate having a n-type semiconductor layer, an active layer, and a p-type semiconductor layer sequentially grown through a chemical vapor deposition apparatus (not shown) into individual dies on a wafer level.

As illustrated in FIG. 1, the light emitting device 10 may include electrode pads 11 formed on the upper surface 10a, the light emitting surface thereof. In addition, as illustrated in FIG. 6, the light emitting device 10 may include electrode pads 11 and 11' respectively formed on the upper surface 10a and the lower surface 10b thereof. Moreover, as illustrated in FIG. 9, the light emitting device 10 may include electrode pads 11' formed on the lower surface 10b thereof. The manufacturing method according to the embodiment of the present invention may be explained with reference to the light emitting device 10 including the electrode pads 11 formed on the upper surface 10a thereof. In a case in which the light emitting device 10 includes the electrode pads 11' formed on the lower surface 10b thereof as in FIG. 9, a process of forming the electrode terminals 50 on the carrier film 100 may be omitted.

The light emitting devices 10 may be mounted on the carrier film 100, corresponding to the respective electrode terminals 50, to thereby have a matrix arrangement.

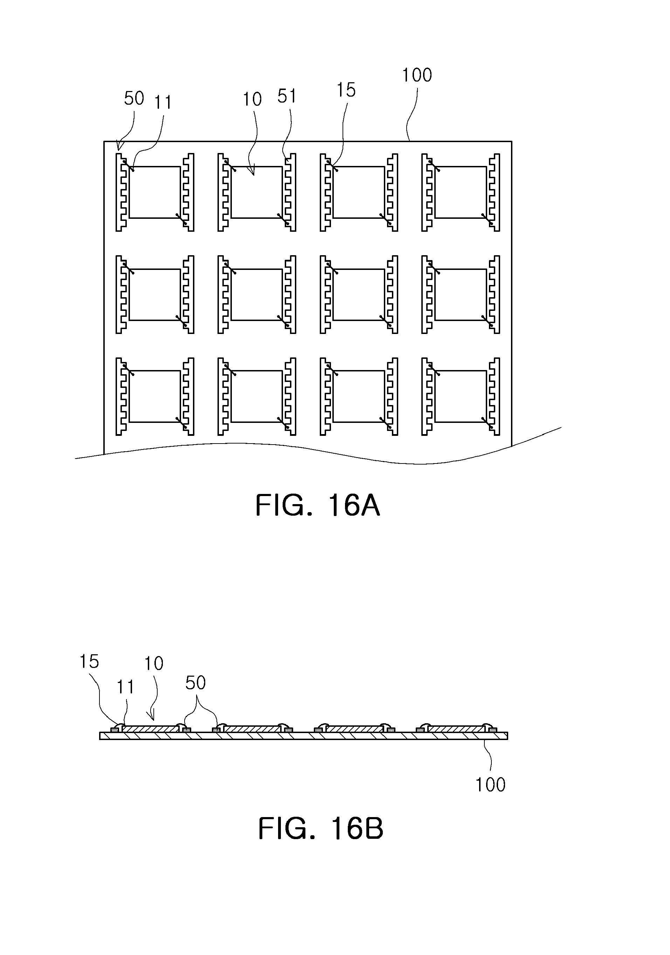

Next, as illustrated in FIG. 16, a respective one end of the bonding wires 15 may be bonded to the electrode pads 11 and the respective other end thereof may be bonded to the electrode terminals 50, such that the light emitting devices 10 and the electrode terminals 50 may be individually electrically connected. Of course, since the electrode terminals 50 does not exist when each of the light emitting devices 10 includes the electrode pads 11' formed on the lower surface 10b thereof as in FIG. 9, a process of connecting the light emitting devices 10 and the electrode terminals 50 may be omitted.

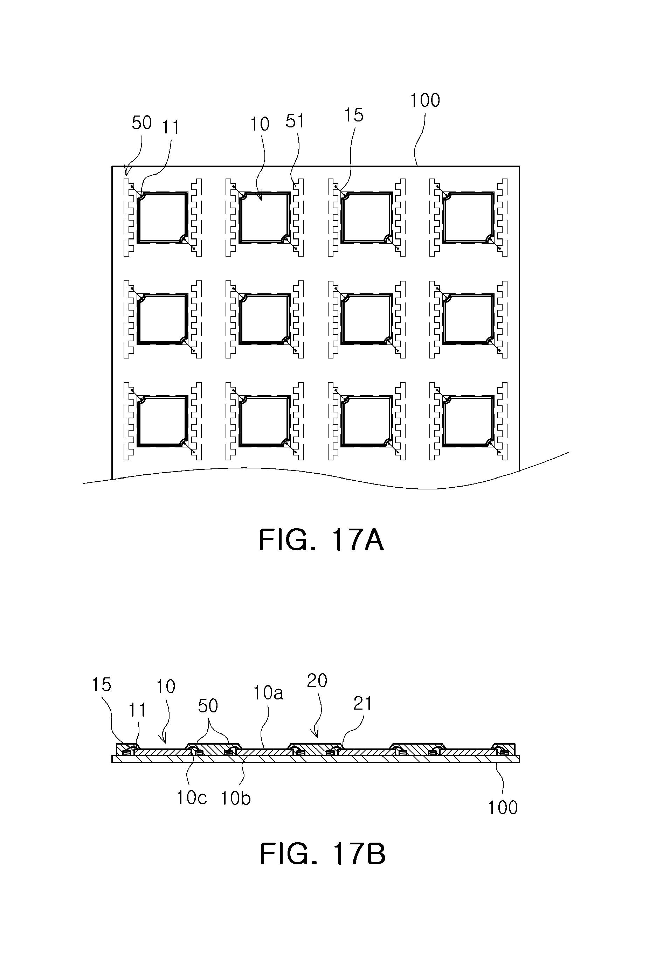

Next, as illustrated in FIG. 17, the body part 20 sealing the light emitting device 10 by injecting a resin in a mold (not shown) may be formed on the carrier film 100.

Concretely, the carrier film 100 having the light emitting device 10 and the electrode terminal 50 connected through the bonding wire 15 may be mounted in the inside of a mold (not shown) to be fixed thereto and then a molding material may be injected in the inside of the mold, such that the body part 20 integrally sealing the light emitting device 10 together with the bonding wire 15 and the electrode terminal 50 may be formed on the carrier film 100. Furthermore, the reflective groove 21 through which the upper surface 10a of the light emitting device 10 is exposed may be formed in the upper surface 20a of the body part 20.

As a molding resin used in the formation of the body part 20, a white molding compound having reflectance may be used, which may lead to an increase in quantity of light, the light being emitted from the side surfaces of the light emitting device and reflected to be thereby upwardly emitted. The white molding compound may include a thermosetting resin series or a silicon resin series having high heat-resisting properties. In addition, the thermosetting resin series may contain a white pigment and filling material, a hardener, a release agent, an antioxidant, an adhesion improver, or the like added therein, and have a high glass transition temperature (Tg) of 100°C or more, a low coefficient of thermal expansion (CTE) of 20 ppm or less, and a high adhesive strength.

As illustrated in FIG. 17, the body part 20 may be molded and formed on the carrier film 100 so as to cover and integrally seal the electrode terminal 50, the bonding wire 15, and the side surfaces 10c, and a part of the upper surface 10a of the light emitting device 10, the part including the electrode pad 11. Thus, the upper surface 10a of the light emitting device 10 exposed through the reflective groove 21 and the lower surface 10b thereof coming into contact with the carrier film 100 may not be sealed by the body part 20.

Meanwhile, as in FIG. 9, in the case of the light emitting device 10 including the electrode pads 11' formed on the lower surface 10b thereof, since the electrode pads 11' come into contact with the carrier film 100 to be mounted thereon, the upper surface 10a of the light emitting device 10 exposed through the reflective groove 21 and the electrode pads 11' thereof coming into contact with the carrier film 100 may not be sealed by the body part 20. Thus, the body part 20 may be molded so as to cover a surface of the light emitting device, except for the electrode pads 11' and the upper surface 10a exposed through the reflective groove. In addition, the body part 20 may be formed in such a manner that the upper surface 20a thereof may be located on the same plane as the upper surface 10a of the light emitting device 10, or located on a plane different from the upper surface 10a of the light emitting device 10.

In this manner, in a post-molding method of forming the body part 20 through the molding of a resin after a connection of the light emitting device 10 and the electrode terminal 50 through the bonding wire 15, a non-valuable process required prior to the injection of a resin material, such as baking, may be omitted to thereby allow for the simplification of the entire process, unlike a pre-molding method according to the related art. In the pre-molding method according to the related art, a light emitting device may be mounted on a body part and wire-bonded in a state in which the body part has been formed. In addition, a degree to which the light emitting device 10 is exposed may be adjusted. That is, a structure of the reflective groove 21 may be adjusted and molded so as to expose only the upper surface of the light emitting device 10. Thus, unnecessary waste of space may be prevented to thereby allow for a reduction in size of a product and a maximization of light concentration efficiency. In particular, the light emitting device 10 and the bonding wire 15 are integrally sealed by the body part 20 having superior mechanical properties, rather than being sealed by a sealing part having low mechanical properties as in the related art, whereby connection reliability between the light emitting device 10 and the bonding wire 15 may be secured.

Next, the fluorescent layer 40 may be formed on the upper surface 10a of the light emitting device 10. The fluorescent layer 40 may contain at least one kind of fluorescent material, such that a wavelength of light emitted from the light emitting device 10 may be converted into a wavelength thereof exhibiting a desired color. In particular, since only the light emitting area (an area from which light is emitted) of the upper surface 10a of the light emitting device 10 may be exposed through the reflective groove 21, the fluorescent layer 40 may allow for the dispersion of fluorescent materials only on the light emitting area of the light emitting device 10, thereby leading to a reduction in the amount of relatively expensive fluorescent materials used.

The fluorescent layer 40 may be formed by injecting a resin containing fluorescent materials in the reflective groove 21 and then curing the resin, by applying a resin to the reflective groove 21 through a method, such as spraying or printing, or by forming a resin in a thin film to attach the thin resin film to the reflective groove 21.

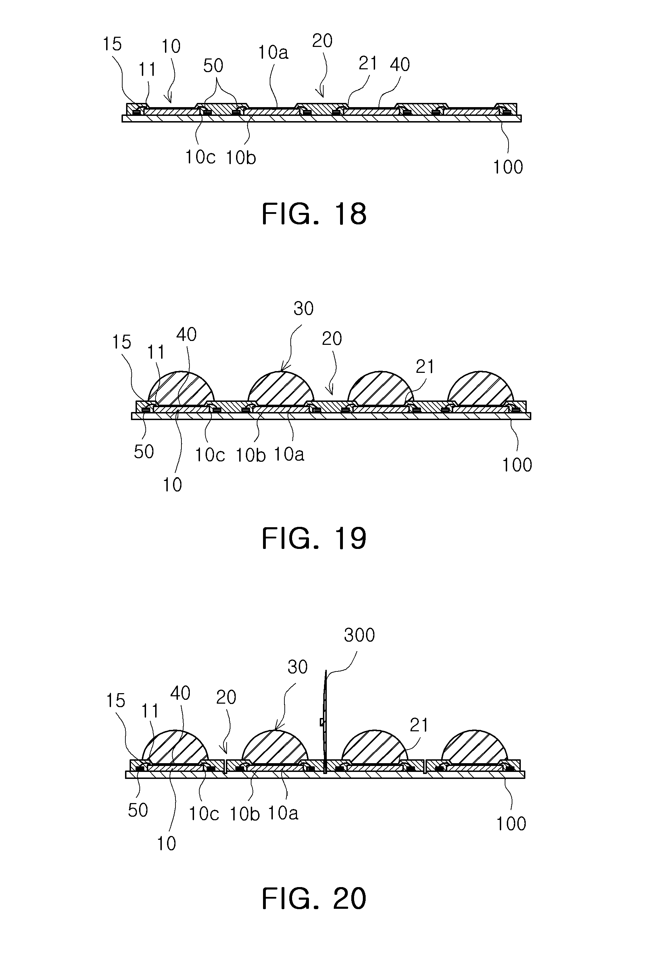

Next, as illustrated in FIG. 19, the lens part 30 may be provided on the body part 20 to cover the light emitting device 10. The lens part 30 may have an upwardly convex dome shape, in order to improve an orientation angle of emitted light. However, the shape of the lens part 30 is not limited thereto.
The lens part 30 may be formed directly on the body part 20 by a molding method, such as a compression molding method, a transfer molding method or the like, or a potting method using a dispenser. The lens part 30 may also be fabricated through a separate process to be adhered to the body part 20 through adhesive or the like.

Next, as in FIG. 20, through dicing performed by a cutting apparatus 300, along a cutting line, separated individual light emitting device packages may be generated. Concretely, the cutting apparatus 300 may allow for the dicing of the body part 20 in such a manner that the carrier film 100 is only cut to a predetermined depth from an upper surface thereof. Thus, the light emitting device package 1 provided in plural may be separated and the plurality of light emitting device packages may be arranged on the carrier film 100.

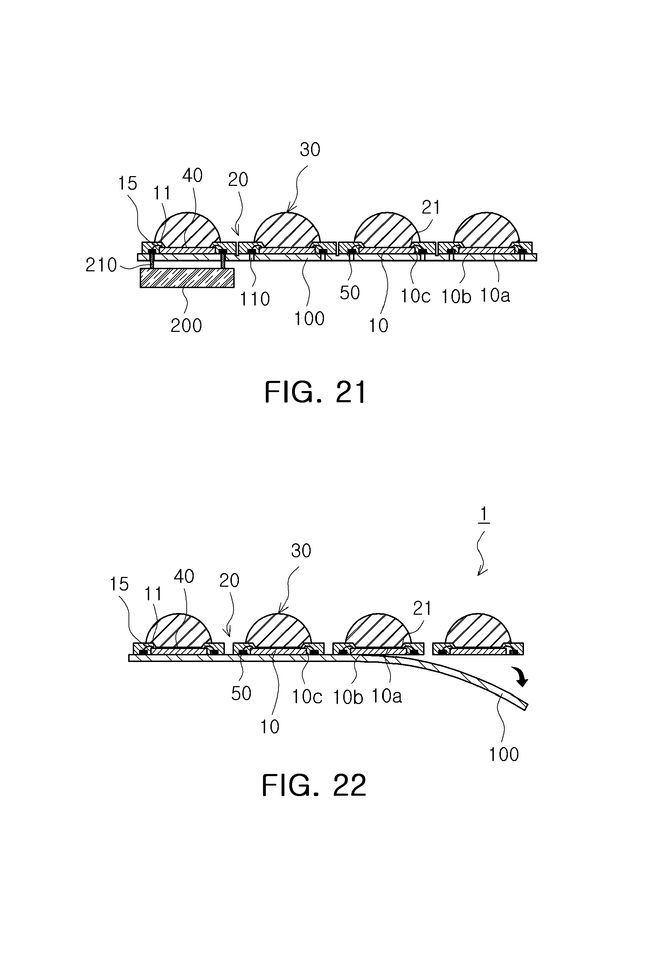

Next, as illustrated in FIG. 21, probe electrodes 210 of a test apparatus 200 may be inserted into probe through holes 110 formed in the carrier film 100, such that the light emitting device 10 may be tested. The probe through holes 110 may be formed in locations of the carrier film 100, the locations electrically connected to the electrode pads 11 of the light emitting device 10. Concretely, as illustrated in FIG. 21, the probe through holes 110 may be formed to penetrate the carrier film 100, corresponding to locations of the electrode terminals 50 electrically connected to the electrode pads 11 of the light emitting device 10. Thus, the probe electrodes 210 inserted into the probe through holes 110 may be connected to the electrode terminals 50, thereby allowing the light emitting device 10 to be driven.

Meanwhile, although not illustrated in FIG. 21, in the case of the light emitting device 10 including the electrode pads 11' formed on the lower surface thereof, the probe through holes 110 may be formed in locations of the carrier film 100, at which the electrode pads 11' and the carrier film 100 come into contact with each other. In this case, the probe electrodes 210 may be directly connected to the electrode pads 11', thereby allowing the light emitting device 10 to be driven.

In this manner, prior to the manufacturing of the individual light emitting device packages 1, tests on the respective light emitting device packages 1 arranged on the carrier film 100 may be undertaken at the same time. Based on test results, a process performed after the manufacturing of a product, such as defectiveness determination and grade classification, may be completed on a manufacturing process level to thereby allow for a simplified process.

Next, as in FIG. 22, the plurality of light emitting device packages 1 may be manufactured by removing the carrier film 100.

As set forth above, according to embodiments of the invention, a bottom surface of a chip, for example the lower surface of the semiconductor material of the chip or the lower surface of one or more electrode pads formed on the semiconductor material of the chip, is exposed at a lower portion of a package body and comes into direct contact with a mounting substrate, such that heat generated during an operation of the light emitting device may be emitted directly to the mounting substrate to thereby allow for a maximization of heat radiation efficiency. The chip may form a light emitting device as described above.

In addition, a chip and a wire are sealed by a molding material having superior mechanical and electrical properties and forming a package, such that connection reliability between the wire and the chip could be improved even in the case of high temperature/high humidity.

Moreover, a direct package test may be undertaken in a package manufacturing process level by using an optional substrate (carrier film) having the probe through holes formed therein, without a separate package holding device, whereby it could be promptly confirmed whether the package to be manufactured, has defects.

In addition, since a molding is performed after a chip bonding and wire bonding processes, a non-valuable process required prior to the injection of a resin material, such as baking, may be omitted to thereby allow for the simplification of the entire process.
While the present invention has been shown and described in connection with the embodiments, it will be apparent to those skilled in the art that modifications and variations can be made without departing from the scope of the invention as defined by the appended claims.

## Claims

1. A light emitting device package, comprising:
a light emitting device (10) including electrode pads (11, 11'); and
a body part (20) supporting the light emitting device (10), including a reflective groove (21) exposing an upper surface (10a) of the light emitting device (10) in an upper surface (20a) thereof, and exposing a lower surface (10b) of the light emitting device (10) through a lower surface (20b) thereof.

2. The light emitting device package of claim 1, wherein the light emitting device (10) includes electrode pads (11) on the upper surface (10a) thereof or the upper surface (10a) and lower surface (10b) thereof, and the electrode pads (11) included on the upper surface (10a) are sealed by the body part (20).

3. The light emitting device package of claim 1 or 2, further comprising bonding wires (15) and electrode terminals (50) electrically connected to the electrode pads (11) through the bonding wires (15),
wherein the bonding wires (15) and the electrode terminals (50) are integrally sealed and supported by the body part (20), together with the light emitting device (10), and the electrode terminals (50) have lower surfaces exposed through the lower surface (20b) of the body part (20).

4. The light emitting device package of claim 3, wherein each of the electrode terminals (50) includes prominences and depressions (51) allowing for enhanced coupling force with the body part (20), on at least one surface thereof.

5. The light emitting device package of claim 1, wherein the light emitting device (10) includes the electrode pads (11') on the lower surface (10b) thereof, and the electrode pads (11') are exposed through the lower surface (20b) of the body part (20).

6. The light emitting device package of claim 5, wherein the light emitting device (10) has side surfaces (10c) sealed by the body part (20), and the side surfaces (10c) are inclined such that the light emitting device (10) has an inverted pyramid shape.

7. The light emitting device package of any of the preceding claims, further comprising a sealing part (60) formed within the reflective groove (21) and covering the upper surface (10a) of the light emitting device (10).

8. The light emitting device package of any of the preceding claims, further comprising a lens part (30) provided on the body part (20) and covering the light emitting device (10).

9. A method of manufacuring a light emitting devce package, the method comprising:
mounting a light emitting device (10) including electrode pads (11, 11') on a carrier film (100);
forming a body part (20) on the carrier film (100) through molding so as to seal the light emitting device (10) by injecting a resin within a mold and to have a reflective groove (21) formed in an upper surface (20a) thereof, the reflective groove (21) exposing an upper surface (10a) of the light emitting device (10); and
removing the carrier film (100).

10. The method of claim 9, further comprising forming a lens part (30) on the body part (20) to cover the light emitting device (10).

11. The method of claim 9 or 10, further comprising patterning electrode terminals (50) on the carrier (100) film before the mounting of the light emitting device (10).

12. The method of claim 11, wherein the light emitting device (10) includes the electrode pads (11) on the upper surface (10a) thereof or includes the electrode pads (11, 11') on the upper surface (10a) and a lower surface (10b) thereof, and
the method further includes electrically connecting the electrode pads (11) included on the upper surface (10a) and the electrode terminals (50) through bonding wires (15).

13. The method of claim 12, wherein in the forming of the body part (20), the light emitting device (10) having the upper surface (10a) exposed through the reflective groove (21) is integrally sealed together with the electrode terminals (50) and the bonding wires (15).

14. The method of any of the claims 9 to 11, wherein the light emitting device (10) includes the electrode pads (11') on a lower surface (10b) thereof coming into contact with the carrier film (100), and in the forming of the body part (20), the body part (20) is molded so as to cover a surface of the light emitting device (10), except for the electrode pads (11') and the upper surface (10a) exposed through the reflective groove (21).

15. The method of any of the claims 9 to 14, further comprising tesing the light emitting device (10) by inserting a probe electrode (210) into a probe through hole (110) provided in the carrier film (100), before the removing of the carrier film (100),
wherein the probe through hole (110) is provided in a location of the carrier film (100) electrically connected to the electrode pads (11, 11').
